# EUROPEAN PATENT SPECIFICATION

(11) **EP 2 658 356 B1**
(45) Date of publication and mention of the grant of the patent: **06.01.2021**
(21) Application number: 11850812.6
(22) Date of filing: 06.01.2011
(51) Int. Cl.: H05K 3/46, H05K 1/02, H01L 33/64

(54) **MANUFACTURING METHOD FOR PRINTED CIRCUIT BOARD WITH INSULATED MICRO RADIATOR**
HERSTELLUNGSVERFAHREN FÜR BESTÜCKTE LEITERPLATTEN MIT EINEM ISOLIERTEN MIKROKÜHLKÖRPER
PROCÉDÉ DE FABRICATION D'UNE CARTE DE CIRCUIT IMPRIMÉ DOTÉE D'UN MICRORADIATEUR ISOLÉ

(30) Priority: 24.12.2010 CN 201010604353
(43) Date of publication of application: 30.10.2013
(73) Proprietor: Rayben Technologies (Zhu Hai) Ltd, Zhuhai, Guangdong 519180 (CN)
(72) Inventor: WANG, Zheng, Zhuhai Guangdong 519180 (CN)
(74) Representative: Cabinet Chaillot
(86) International application number: PCT/CN2011/070051
(87) International publication number: WO 2012/083595

(56) References cited:
- CN-A- 101 790 290
- CN-A- 101 790 290
- US-A1- 2004 156 175
- US-A1- 2009 040 727
- US-A1- 2009 301 765

## Description

### FIELD OF THE INVENTION

The invention relates to the technical field of a printed circuit board (PCB), in particular to a novel PCB manufacturing method combining an insulated micro radiator with a conventional PCB.

### BACKGROUND OF THE INVENTION

The printed circuit board (PCB) is one of the important components in the electronic industry. The PCB can provide a fixed and assembled mechanical support for electronic components and realize the electrical connection between the electronic components. Additionally, the PCB, printed with the legend of components and some graphics, provides convenience for soldering, inspecting and repairing the components. Almost every electronic device, whether which is a small one such as an electronic watch, a calculator and so on or which is a large one such as a computer, a telecommunication equipment, a military weapon system , shall use PCBs for their electrical connection as long as the electronic device contains the electronic components such as Integrated Circuits (ICs) and so on.

The conventional PCB adopts a Plated Through Hole (PTH) structure. The insulating material between copper layers is FR4 material. Its thermal conductivity is 0.4W/mk and hence it has relatively low heat transfer capability. As to a metal core PCB (MCPCB) developed in recent years, the thermal conductivity of the insulating material between metal layers is 1.3-2.2W/mk and it has still limited heat transfer capability. For a PCB provided with a large number of ICs, especially a PCB provided with high-power light emitting diodes (LEDs), the heat generated by IC array or LED array during the operation is quite high and the specified operation temperature is low (about 60 degrees Celsius). Then the PCB thermal conductivity is required to be tens or hundreds of W / mk, obviously being far beyond the thermal conductivity of the insulating material in the prior art.

CN101790290A discloses a manufacturing method for high-efficiency heat conduction embedded PCB.

US2009/040727A1 discloses a circuit carrier structure with improved heat dissipation.

US2004/156175A1 discloses a heat dissipating structure of printed circuit board and fabricating method thereof.

US2009301765A1 discloses a printed circuit board, comprising: at least one via hole, in which a heat dissipating element is arranged, wherein at least one radiant source is arranged on the heat dissipating element.

### SUMMARY OF THE INVENTION

To answer the PCB challenge in the prior art, the object of the invention is to provide a manufacturing method of a PCB with an insulated micro radiator.

The object of the invention is realized through the following technical proposal: a manufacturing method of a PCB with an insulated micro radiator includes the following steps:
Step A210: providing a high thermal conductivity electrical insulating substrate of which top and bottom surfaces are both clad with copper foils, and cutting the electrical insulating substrate into one or a number of cylindrical insulated micro radiators of which top and bottom surfaces are both clad with the copper foils, according to the predetermined size;
Step A220: providing N(N> 1) layers copper clad laminates with one or two surfaces clad with copper foils and N-1 layers prepregs; cutting them into working panels of the PCB according to predetermined size, and making inner-layer circuits of the PCB on the corresponding copper foils of the copper clad laminates, with adoption of the conventional image transferring method for a PCB copper pattern;
Step A230: at the corresponding locations of the copper clad laminates and the prepregs, according to the size of the insulated micro radiator obtained in Step A210, through the adoption of drilling, milling or punching, installation holes for the insulated micro radiators are made, and the shape and size of the installation holes and those of the insulated micro radiator are in one-to-one correspondence;
Step A240: alternately laying up the copper clad laminates and the prepregs with the conventional multi-layer PCB laying up method; making two copper clad laminates to be located at the top and the bottom layers of the PCB respectively, the copper foil surfaces of the copper clad laminates must be outwards to the PCB, and plugging the insulated micro radiators into the corresponding installation holes;
Step A250: pressing the copper clad laminates and the prepregs together with the standard pressing method of the conventional multi-layer PCB;
Step A260: according to the manufacturing method of a conventional PCB, carrying out hole drilling, Plated Through Hole (PTH) plating, outer-layer image transferring, solder resist printing, surface finishing, outline fabrication for laminated working panels and soldering heating components on top copper pattern of the insulated micro radiator.

As the preferable technical proposal of the invention, in Step A220 and Step A260: during the manufacturing process for the PCB inner-layer and outer-layer circuits, the provided heating component installing copper pattern of the insulated micro radiator is electrically connected with the PCB inner-layer and / or outer-layer circuits, and the other copper pattern of the insulated micro radiator is insulated from both the inner-layer and outer-layer circuits of the PCB.

As the preferable technical proposal of the invention, in Step A240: the one surface copper clad laminates locate at the bottom and the top layers of the PCB, the copper foil surfaces of the one surface copper clad laminates must be outwards to the PCB.

As the preferable technical proposal of the invention, the heating component is an LED component or an LED chip.

As the preferable technical proposal of the invention, in the Step A210, the electrical insulating substrate can be cut into the insulated micro radiator in elliptical cylindrical shape, cube shape, or cylinder shape with its top and bottom surfaces both in diamond shape, triangular shape or trapezoidal shape.

As the preferable technical proposal of the invention, the insulated micro radiator is made of electrical insulating materials with high thermal conductivity of alumina ceramic, aluminum nitride ceramic, silicon carbide, diamond, etc.

Compared with the prior art, the invention combines a high thermal conductivity insulated micro radiator with a conventional rigid PCB. The PCB has the advantages of high thermal conductivity and heat transfer stability of the insulated micro radiator as well as the advantages of flexible routing and reliable electrical connection of the conventional PCB. Moreover, it can transmit the heat generated by heating component such as an LED component and so on out of the PCB in the process of the operation, timely and effectively. Therefore, it is an ideal carrier board for the heating component and an array thereof. The manufacturing method has the advantages of simple, convenience for operation and good productivity.

### DRAWINGS OF THE INVENTION

The invention will be further described in more details with the combination of drawings and embodiments:
FIG.1 is a section diagram of a PCB with an insulated micro radiator.
FIG.2 is a flow chart of manufacturing method of a PCB with an insulated micro radiator shown in FIG.1.

### DETAILED DESCRIPTION OF THE INVENTION

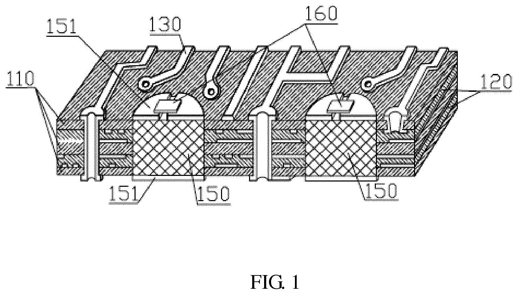

FIG.1 is a section diagram of a preferable embodiment of the invention.

As shown in FIG.1, the printed circuit board (PCB) is a rigid PCB and includes sequentially alternately laminated three copper clad laminates 110 and two solidified piece 120, wherein top and bottom of the PCB are both the copper clad laminates 110. The top and bottom surfaces of the copper clad laminates 110 are both clad with copper circuit layer 130. The PCB also includes two cylindrical insulated micro radiators 150 respectively embedded in two cylindrical through holes of the PCB. The height of the insulated micro radiator 150, with top and bottom surfaces both clad with copper patterns 151, is equal to the thickness of the PCB. One LED chip 160 is provided on the top copper patterns 151 respectively. The power inputs (not shown in figures) of LED chip 160 and inner circuit layers of the PCB are electrically connected. The bottom copper patterns 151 of the insulated micro radiators 150 are electrically insulated from both the inner-layer and outer-layer circuits of the PCB.

The insulated micro radiator 150 is made of electrical insulating materials with high thermal conductivity of alumina ceramic, aluminum nitride ceramic, silicon carbide, diamond, etc. The thermal conductivity between top and bottom copper patterns 151 of the insulated micro radiator 150 can be as high as 20-1000W/mk.

In the process of the operation of the PCB, LED chip 160 is switched on and emits light and generates heat. The heat is transmitted from top copper patterns 151, through the insulated micro radiators 150, to the bottom copper patterns 151, and then to the outer side of the PCB.

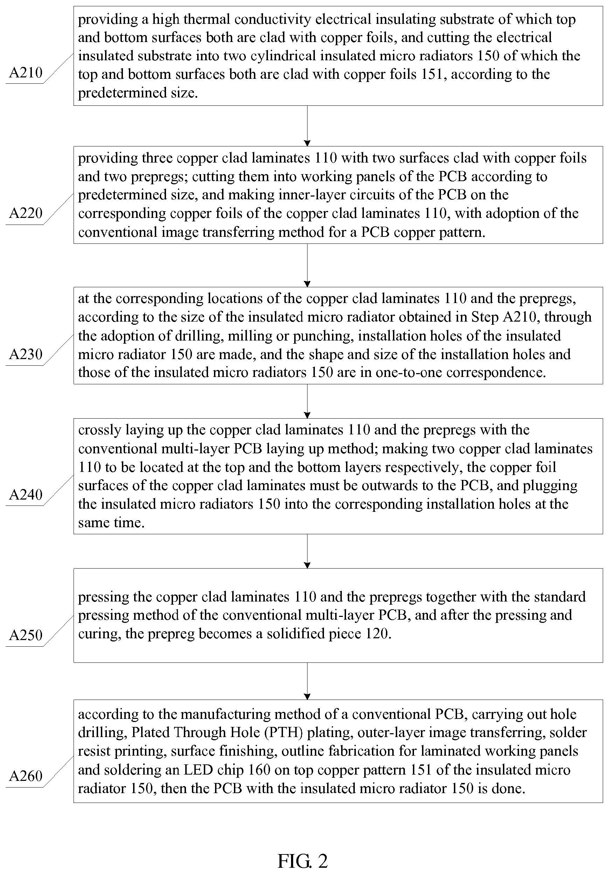

FIG.2 shows a flow chart of a manufacturing method of a PCB with an insulated micro radiator shown in FIG.1. The method includes the following steps:
Step A210: providing a high thermal conductivity electrical insulating substrate of which top and bottom surfaces both are clad with copper foils, and cutting the electrical insulated substrate into two cylindrical insulated micro radiators 150 of which the top and bottom surfaces are both clad with copper foils 151, according to the predetermined size;
Step A220: providing three copper clad laminates 110 with two surfaces clad with copper foils and two prepregs; cutting them into working panels of the PCB according to predetermined size, and making inner-layer circuits of the PCB on the corresponding copper foils of the copper clad laminates 110, with adoption of the conventional image transferring method for a PCB copper pattern;
Step A230: at the corresponding locations of the copper clad laminates 110 and the prepregs, according to the size of the insulated micro radiator obtained in Step A210, through the adoption of drilling, milling or punching, installation holes of the insulated micro radiator 150 are made, and the shape and size of the installation holes and those of the insulated micro radiators 150 are in one-to-one correspondence;
Step A240: alternately laying up the copper clad laminates 110 and the prepregs with the conventional multi-layer PCB laying up method; making two copper clad laminates 110 to be located at the top and the bottom layers respectively, the copper foil surfaces of the copper clad laminates must be outwards to the PCB, and plugging the insulated micro radiators 150 into the corresponding installation holes at the same time;
Step A250: pressing the copper clad laminates 110 and the prepregs together with the standard pressing method of the conventional multi-layer PCB, and after the pressing and curing, the prepreg becomes a solidified piece 120;
Step A260: according to the manufacturing method of a conventional PCB, carrying out hole drilling, Plated Through Hole (PTH) plating, outer-layer image transferring, solder resist printing, surface finishing, outline fabrication for laminated working panels and soldering an LED chip 160 on top copper pattern 151 of the insulated micro radiator 150.

It shall be noted that: during the manufacturing process of the inner-layer and outer-layer circuits of the PCB, the top copper pattern 151 for the provided LED chip 160 of the insulated micro radiator 150 shall be guaranteed to be electrically connected with the inner-layer and/or outer-layer circuits of the PCB, and the bottom copper pattern 151 of the insulated micro radiator 150 (that is, the copper pattern is not installed with the LED chip 160) is insulated from both inner-layer and outer-layer circuits of the PCB.

The manufacturing method of a PCB with an insulated micro radiator of the invention is not just limited to the abovementioned preferable embodiments. The equal variants and modifications of the invention are all covered within the scope of the claims of the invention. For example:
In Step A260, the top copper pattern 151 of the insulated micro radiator 150 can be provided with heating components including LED components or Integrated Circuit components;
In Step A220, N(N> 1) layers copper clad laminates and N-1 layers prepregs can be provided to make a 2N-layer PCB;
In step A220, the provided copper clad laminates can be either two surfaces copper clad laminates or one surface copper clad laminates. If it is the one surface copper clad laminate, when the copper clad laminates and the prepregs are laid up, for the copper clad laminates located at top and bottom layers of the PCB, the copper foil surfaces of the copper clad laminates must be outwards to the PCB.

In the Step A210, the electrical insulated substrate can be cut into the insulated micro radiators in elliptical cylindrical shape, cube shape, or cylinder shape with top and bottom surfaces both in diamond shape, triangular shape or trapezoidal shape; according to the needs of an actual design, there can be one or a number of the cut insulated micro radiators.

The heating component of the invention is electrically connected with inner-layer and / or outer-layer circuits of the PCB.

## Claims

1. A manufacturing method for a printed circuit board (PCB) with an insulated micro radiator, the method comprising the following steps:
Step A210: providing a high thermal conductivity electrical insulating substrate of which top and bottom surfaces are both clad with copper foils, and cutting the electrical insulating substrate into one or a number of cylindrical insulated micro radiators (150), of which top and bottom surfaces are both clad with copper foils (151), according to the predetermined size;
Step A220: providing N(N> 1) layers copper clad laminates (110) with one or two surfaces clad with copper foils and (N-1) layers prepregs; cutting them into working panels of the PCB according to predetermined size, and making inner-layer circuits of the PCB on the corresponding copper foils of the copper clad laminates (110), with adoption of the conventional image transferring method for a PCB copper pattern;
Step A230: at the corresponding locations of the copper clad laminates (110) and the prepregs, according to the size of the insulated micro radiators obtained in Step A210, through the adoption of drilling, milling or punching, installation holes of the insulated micro radiator (150) are made, and the shape and size of the installation holes and those of the insulated micro radiators (150) are in one-to-one correspondence;
Step A240: alternately laying up the copper clad laminates (110) and the prepregs with the conventional multi-layer PCB laying up method; making two copper clad laminates (110) to be located at the top and the bottom layers respectively, the copper clad laminates (110) located at top and bottom layers are required to be copper foil surfaces outwards to the PCB, and plugging the insulated micro radiators (150) into corresponding installation holes;
Step A250: pressing the copper clad laminates (110) and the prepregs together with the standard pressing method of the conventional multi-layer PCB;
Step A260: according to the manufacturing method of a conventional PCB, carrying out hole drilling, Plated Through Hole plating, outer-layer image transferring, solder resist printing, surface finishing, outline fabrication for laminated working panels and soldering heating components on top copper patterns (151) of the insulated micro radiators (150).

2. The manufacturing method of the PCB with the insulated micro radiator according to claim 1, wherein in the Step A210, the electrical insulating substrate with high thermal conductivity is cut into the insulated micro radiator (150) in elliptical cylindrical shape, cube shape, or cylinder shape with top and bottom surfaces both in diamond shape, triangular shape or trapezoidal shape.

3. The manufacturing method of the PCB with the insulated micro radiator according to claim 1, wherein in Step A210: the electrical insulating substrate with high thermal conductivity is made of electrical insulating materials of alumina ceramic, aluminum nitride ceramic, silicon carbide, diamond, etc.

4. The manufacturing method of the PCB with the insulated micro radiator according to claim 1, wherein in Step A220 and Step A260: during the manufacturing process of inner-layer and outer-layer circuits of the PCB, the top copper pattern (151) of the insulated micro radiator (150) for the provided heating component is electrically connected with inner-layer and / or outer-layer circuits of the PCB, and the bottom copper pattern (151) of the insulated micro radiator (150) is insulated from both inner-layer and outer-layer circuits of the PCB.

5. The manufacturing method of the PCB with the insulated micro radiator according to claim 1, wherein in Step A240: the copper clad laminates (110) with one surface clad with copper foil locate at the top and the bottom layers of the PCB, the copper foil surfaces of the copper clad laminates (110) must be outwards to the PCB.

6. The manufacturing method of the PCB with the insulated micro radiator according to claim 1, wherein the heating component is an LED component or an LED chip (160).

## Patentansprüche

1. Herstellungsverfahren für eine Leiterplatte (PCB) mit einem isolierten Mikrokühlkörper, wobei das Verfahren die folgenden Schritte umfasst:
Schritt A210: Bereitstellen eines elektrisch isolierenden Substrats mit einer hohen Wärmeleitfähigkeit, dessen obere und unter Fläche beide mit Kupferfolien verkleidet sind, und Schneiden des elektrisch isolierenden Substrats in einen oder eine Anzahl von zylindrischen isolierten Mikrokühlkörpern (150), dessen obere und unter Fläche beide mit Kupferfolien (151) verkleidet sind, je nach der vorbestimmten Größe;
Schritt A220: Bereitstellen von N(N> 1) Schichten von kupferverkleideten Laminaten (110) mit einer oder zwei Flächen, die mit Kupferfolien und (N-1) Schichtprepregs verkleidet sind; Schneiden derselben in Arbeitsplatten der PCB je nach der vorbestimmten Größe, und Erstellen der Innenschichtleiter der PCB auf den entsprechenden Kupferfolien der kupferverkleideten Laminate (110) unter Anwendung des herkömmlichen Bildübertragungsverfahrens für ein PCB-Kupfermuster;
Schritt A230: an den entsprechenden Stellen der kupferverkleideten Laminate (110) und der Prepregs je nach der Größe der isolierten Mikrokühlkörper, erhalten in Schritt A210, werden durch die Anwendung von Bohren, Fräsen oder Stanzen Installationslöcher des isolierten Mikrokühlkörpers (150) erstellt, und die Form und Größe der Installationslöcher und derjenigen der isolierten Mikrokühlkörper (150) entsprechen sich eins zu eins;
Schritt A240: alternativ Auflegen der kupferverkleideten Laminate (110) und der Prepregs mit dem herkömmlichen Mehrschicht-PCB-Auflageverfahren; Erstellen von zwei kupferverkleideten Laminaten (110), um sich an der oberen bzw. unteren Schicht zu befinden, die kupferverkleideten Laminate (110), die sich an oberen und unteren Schicht befinden, müssen Kupferfolienflächen außerhalb der PCB sein, und Einstecken der isolierten Mikrokühlungen (150) in entsprechende Installationslöcher;
Schritt A250: Zusammenpressen der kupferverkleideten Laminate (110) und der Prepregs mit dem Standardpressverfahren der herkömmlichen Mehrschicht-PCB;
Schritt A260: gemäß dem Herstellungsverfahren einer herkömmlichen PCB Ausführen des Lochbohrens, Plattieren der Durchkontaktierung, Bildübertragen der Außenschicht, Lötstoppdruck, Oberflächen-Endbearbeitung, Umrissherstellung für laminierte Arbeitsplatten und Löten von Heizkomponenten auf obere Kupfermuster (151) der isolierten Mikrokühlkörper (150).

2. Herstellungsverfahren der PCB mit dem isolierten Mikrokühlkörper nach Anspruch 1, wobei bei Schritt A210 das elektrisch isolierende Substrat mit hoher Wärmeleitfähigkeit in die isolierten Mikrokühlkörper (150) in elliptisch zylindrischer Form, Würfelformoder zylindrischer Formgeschnitten wird, wobei die obere und untere Fläche beide eine Diamantenform, eine dreieckige Form oder eine Trapezform aufweisen.

3. Herstellungsverfahren der PCB mit dem isolierten Mikrokühlkörper nach Anspruch 1, wobei bei Schritt A210: das elektrisch isolierende Substrat mit hoher Wärmeleitfähigkeit aus elektrisch isolierenden Materialien aus Aluminiumoxidkeramik, Aluminiumnitridkeramik, Siliciumcarbid, Diamant usw. erstellt ist.

4. Herstellungsverfahren der PCB mit dem isolierten Mikrokühlkörper nach Anspruch 1, wobei in Schritt A220 und Schritt A260: während des Herstellungsverfahrens der Innen- und Außenschichtleiter der PCB das obere Kupfermuster (151) des isolierten Mikrokühlkörpers (150) für die bereitgestellte Heizkomponenteelektrisch mit den Innen- und/oder Außenschichtleitern der PCB verbunden ist und das untere Kupfermuster (151) des isolierten Mikrokühlkörpers (150) sowohl vom Innen- als auch vom Außenschichtleiter der PCB isoliert ist.

5. Herstellungsverfahren der PCB mit dem isolierten Mikrokühlkörper nach Anspruch 1, wobei bei Schritt A240: sich die kupferverkleideten Laminate (110), wobei eine Fläche mit Kupferfolie bekleidet ist, an der oberen und unteren Schicht der PCB befinden, wobei die Kupferfolienflächen der kupferverkleideten Laminate (110) außerhalb der PCB angeordnet sein müssen.

6. Herstellungsverfahren der PCB mit dem isolierten Mikrokühlkörper nach Anspruch 1, wobei die Heizkomponente eine LED-Komponente oder ein LED-Chip (160) ist.

## Revendications

1. Procédé de fabrication pour une carte de circuits imprimés (PCB) avec un micro-radiateur isolé, le procédé comprenant les étapes suivantes :
étape A210 : fournir un substrat électriquement isolant à haute conductivité thermique dont les surfaces supérieure et inférieure sont toutes deux revêtues de feuilles de cuivre, et découper le substrat électriquement isolant en un ou un nombre de micro-radiateurs isolés cylindriques (150), dont les surfaces supérieure et inférieure sont toutes deux revêtues de feuilles de cuivre (151), en fonction de la taille prédéterminée ;
étape A220 : fournir des stratifiés revêtus de cuivre à N (N >1) couches (110) avec une ou deux surfaces revêtues de feuilles de cuivre et des pré-imprégnés à (N-1) couches ; découper ceux-ci en des panneaux de travail pour la PCB selon la taille prédéterminée, et réaliser des circuits de couche interne de la PCB sur les feuilles de cuivre correspondantes des stratifiés revêtus de cuivre (110), avec une adoption du procédé de transfert d'image conventionnel pour un motif de cuivre de PCB ;
étape A230 : aux emplacements correspondants des stratifiés revêtus de cuivre (110) et des pré-imprégnés, selon la taille des micro-radiateurs isolés obtenus en étape A210, par l'adoption d'un perçage, d'un fraisage ou d'un poinçonnage, des trous d'installation du micro-radiateur isolé (150) sont réalisés, et la forme et la taille des trous d'installation et de ceux des micro-radiateurs isolés (150) sont en correspondance biunivoque ;
étape A240 : empiler alternativement les stratifiés revêtus de cuivre (110) et les pré-imprégnés avec le procédé d'empilage de PCB multicouche conventionnel ; amener deux stratifiés revêtus de cuivre (110) à être situés aux couches supérieure et inférieure respectivement, les stratifiés revêtus de cuivre (110) situés aux couches supérieure et inférieure devant être des surfaces de feuille de cuivre vers l'extérieur de la PCB, et enficher les micro-radiateurs isolés (150) dans les trous d'installation correspondants ;
étape A250 : presser les stratifiés revêtus de cuivre (110) et les pré-imprégnés ensemble avec le procédé de pressage standard des PCB multicouches conventionnelles ;
étape A260 : selon le procédé de fabrication d'une PCB conventionnelle, réaliser un perçage de trou, une métallisation de trou traversant métallisé, un transfert d'image de couche externe, une impression de réserve de soudure, une finition de surface, une fabrication de contour pour des panneaux de travail stratifiés et souder des composants chauffants sur des motifs de cuivre supérieurs (151) des micro-radiateurs isolés (150).

2. Procédé de fabrication de la PCB avec le micro-radiateur isolé selon la revendication 1, dans lequel dans l'étape A210, le substrat électriquement isolant avec une conductivité thermique élevée est découpé en le micro-radiateur isolé (150) sous une forme cylindrique elliptique, une forme de cube, ou une forme de cylindre avec des surfaces supérieure et inférieure toutes deux en forme de diamant, de forme triangulaire ou de forme trapézoïdale.

3. Procédé de fabrication de la PCB avec le micro-radiateur isolé selon la revendication 1, dans lequel dans l'étape A210 : le substrat électriquement isolant avec une conductivité thermique élevée est constitué de matériaux électriquement isolant de céramique d'alumine, de céramique de nitrure d'aluminium, de carbure de silicium, de diamant, etc.

4. Procédé de fabrication de la PCB avec le micro-radiateur isolé selon la revendication 1, dans lequel dans l'étape A220 et l'étape A260 : pendant le processus de fabrication de circuits de couche interne et de couche externe de la PCB, le motif de cuivre supérieur (151) du micro-radiateur isolé (150) pour le composant chauffant prévu est relié électriquement avec des circuits de couche interne et/ou de couche externe de la PCB, et le motif de cuivre inférieur (151) du micro-radiateur isolé (150) est isolé à la fois de circuits de couche interne et de couche externe de la PCB.

5. Procédé de fabrication de la PCB avec le micro-radiateur isolé selon la revendication 1, dans lequel dans l'étape A240 : les stratifiés revêtus de cuivre (110) avec une surface revêtue d'une feuille de cuivre se situent aux couches supérieure et inférieure de la PCB, les surfaces de feuille de cuivre des stratifiés revêtus de cuivre (110) doivent être vers l'extérieur de la PCB.

6. Procédé de fabrication de la PCB avec le micro-radiateur isolé selon la revendication 1, dans lequel le composant chauffant est un composant de DEL ou une puce de DEL (160).
